Europäisches Patentamt

(19) European Patent Office

Office européen des brevets

(11) Publication number : **0 475 574 A1**

(12) **EUROPEAN PATENT APPLICATION**

(21) Application number : 91307174.2

(22) Date of filing : 05.08.91

(51) Int. Cl.⁵ : **C23C 14/24**

(30) Priority : 09.08.90 CA 2023044

(43) Date of publication of application :
18.03.92 Bulletin 92/12

(84) Designated Contracting States :
BE DE FR GB IT NL

(71) Applicant : NORANDA INC.
P.O. Box 45 Suite 4500 Commerce Court West
Toronto Ontario, M5L 1B6 (CA)

(72) Inventor : **Araj, Naoum**
**5466 Avenue Brodeur**
**Montreal, Quebec, H4A 1J3 (CA)**
Inventor : **Davis, John H.**
**414 Halford Road**
**Beaconsfield, Quebec H9W 3L4 (CA)**

(74) Representative : **Thomas, Roger Tamlyn et al**
**D. Young & Co. 10 Staple Inn**
**London WC1V 7RD (GB)**

(54) **Vessel for evaporation of low-temperature melting material.**

(57) A vessel for evaporation of low-temperature melting material comprises an open top compartment for holding a low-temperature melting material, and a lower closed chamber having an inlet and an outlet and a plurality of heat transfer fluid conducting paths between the inlet and outlet designed to minimize temperature difference between the inlet and outlet of the lower chamber.

EP 0 475 574 A1

Jouve, 18, rue Saint-Denis, 75001 PARIS

This invention relates to a vessel for, particularly but not exclusively, vacuum thermal deposition of materials such as selenium, tellurium, arsenic triselenide and other materials which may, for example, be evaporated in the temperature range of 20 to 600°C.

The conventional vessels used in vacuum thermal evaporation are exclusively electrically heated vessels commonly called boats. The boat composition and configuration depend generally on the nature of the material to be evaporated, the thermal evaporation conditions to be applied and the manufacturing throughput requirements, A wide range of boat designs have been developed and have been extensively used in thin film manufacturing processes. However, when a tight control of spatial and temporal temperature profiles for large area boats is required, electrically heated boats are inappropriate and it is very difficult to achieve the required temperature tolerances using such boats. Thus, there is a need for an evaporation vessel design having an improved temperature control.

The vessel in accordance with the present invention comprises an open top compartment for holding a low-temperature melting material and a lower closed chamber having an inlet and an outlet and a plurality of heat transfer fluid conducting paths between such inlet and outlet designed to minimize temperature difference between the inlet and outlet.

The lower chamber may consist of a top plate in which several equally spaced parallel channels are machined and a bottom plate welded to the ribs formed between the channels thereby closing the chamber.

The channels may be machined for series or parallel flow of the heat transfer fluid between the inlet and outlet of the closed chamber.

The invention will now be disclosed, by way of example, with reference to the accompanying drawings in which:

Figure 1 is a perspective view of an evaporation vessel in accordance with the present invention used in a conventional vacuum coater for evaporation of low-temperature melting material;

Figures 2a and 2b illustrate a side and a bottom view, respectively, of an evaporation vessel in accordance with the present invention;

Figure 3 is a view taken along line 3-3 of Figure 2b;

Figure 4 illustrates an evaporation vessel in accordance with the present invention connected to a fluid heater circulator;

Figure 5 shows the temperature profiles at different locations of the evaporation vessel;

Figure 6 shows film thickness uniformity; and

Figure 7 illustrates an evaporation vessel in accordance with the present invention with two fluid circulators, one for heating and one for cooling.

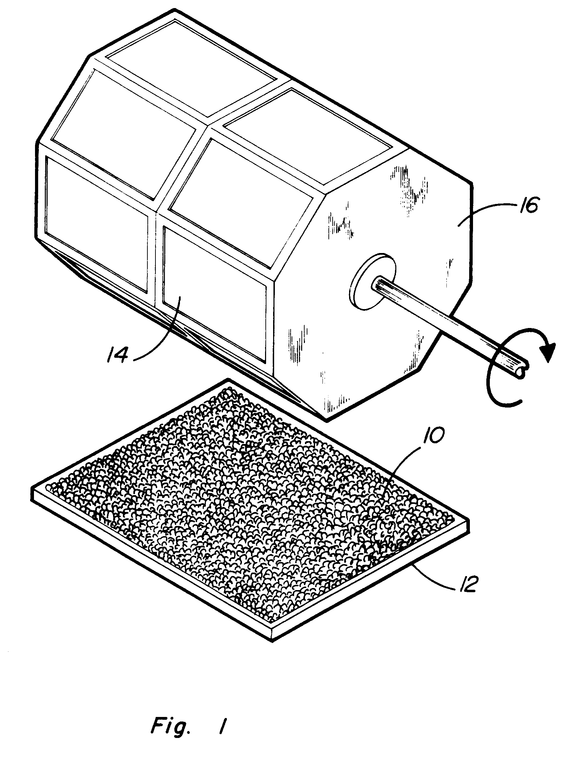

Referring to Figure 1 of the drawings, there is shown a low-temperature melting material 10 contained in an evaporation vessel 12 made in accordance with the present invention. The material in the vessel, typically selenium, is evaporated in a vacuum coater (not shown) under a vacuum pressure in the range of $10^{-4}$ to $10^{-6}$ millibar. Selenium vapors are deposited on a series of aluminum plates 14 mounted on a rotary drum 16 which is located within the vacuum coater. It is to be understood, however, that the evaporation vessel in accordance with the present invention could be used in other types of vacuum coater.

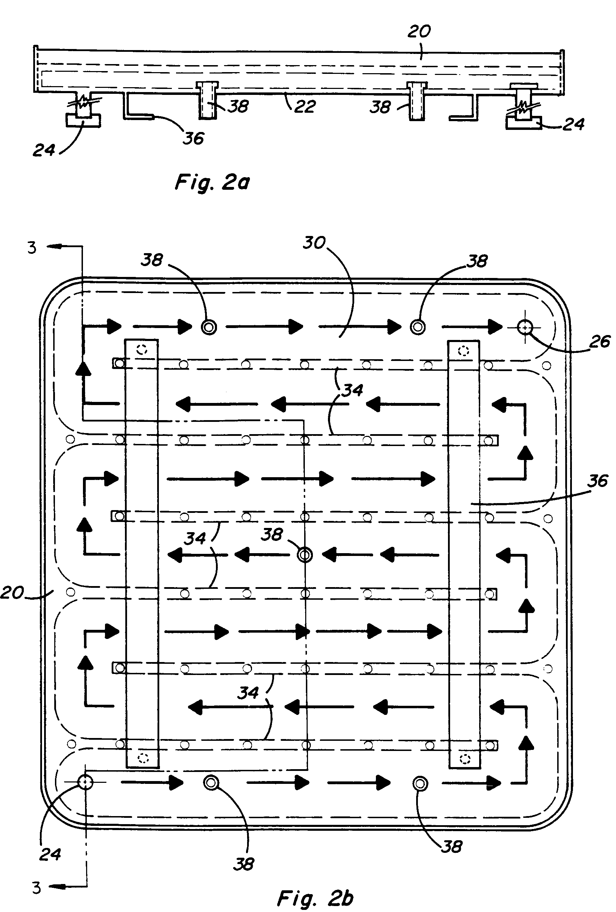

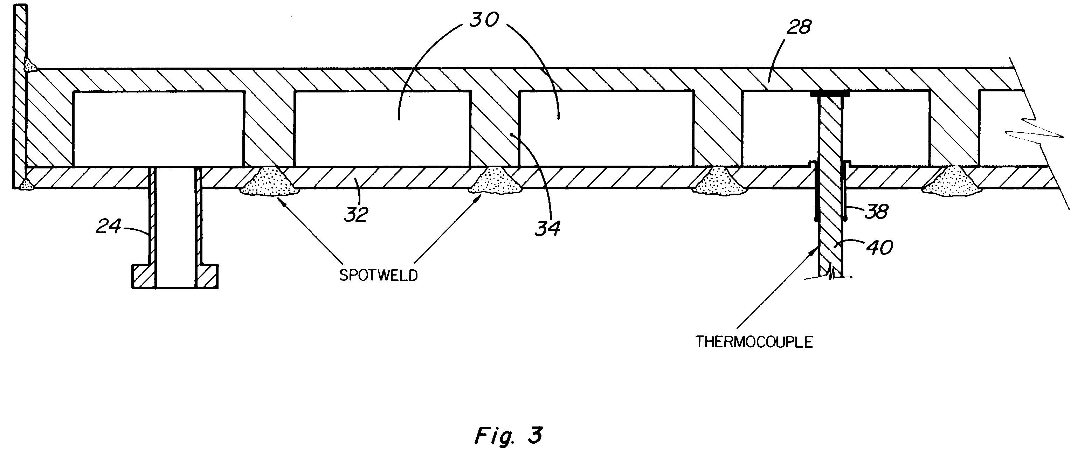

Figures 2a and 2b illustrate an embodiment of a vessel which consists of an open top compartment 20 for holding low-temperature melting material, such as selenium, and a lower closed chamber 22 which is provided with an inlet 24 and an outlet 26 and a plurality of heat transfer fluid conducting paths between such inlet and outlet. Referring more particularly to Figure 3, the lower chamber is formed by an upper plate 28 having parallel channels 30 machined therein for series flow of the heat transfer fluid, A bottom plate 32 is welded to the ribs 34 left between the channels 30 between the inlet and the outlet to close the chamber. It is to be understood that the parallel channels 30 may be machined for parallel flow of the heat transfer fluid between the inlet and outlet of the chamber, the important point being that they be designed to ensure minimum temperature difference between the inlet and outlet of the closed chamber.

The evaporation vessel is supported on legs 36, Fittings 38 are also provided at various locations through the bottom plate 32 for the insertion of thermocouples 40.

The material used in the construction of one particular vessel was stainless steel 304. However, this invention is not limited by that material and other suitable materials could be used. Because of the relatively large vessel area in the presence of full vacuum conditions, the structure of the vessel must be strong enough to withstand a vacuum pressure of 100 kPa and also a fluid dynamic pressure of 70 kPa. A typical structure consists of a plate about 12 mm thick into which a series of grooves typically 5 cm wide and 10 mm deep are machined, leaving 10 mm wide ribs between the grooves to which a bottom plate typically 1,5 mm thick is welded. Such a structure has been tested to 200 kPa of internal pressure and has not shown any noticeable deflection or mechanical deformation when vacuum was applied.

The fluid thickness layer inside the lower chamber, the channel width and the diameter of the inlet and outlet pipes must be optimized in order to minimize pressure drop in the fluid and improve the circulation flow inside the vessel so as to minimize temperature drop between the inlet and outlet of the chamber.

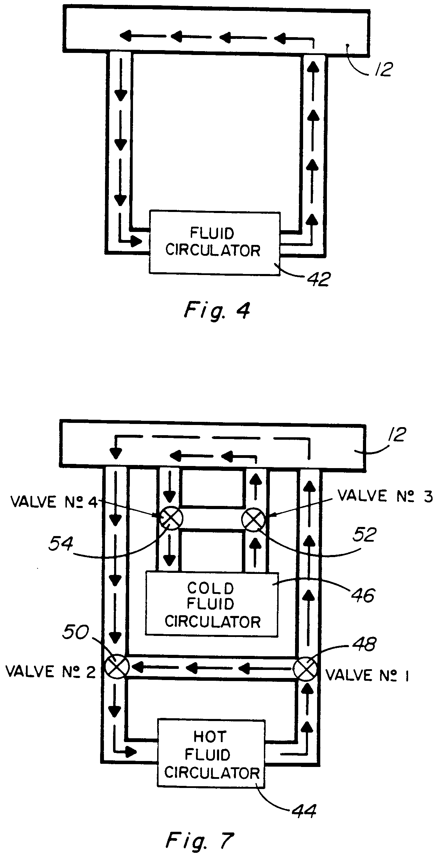

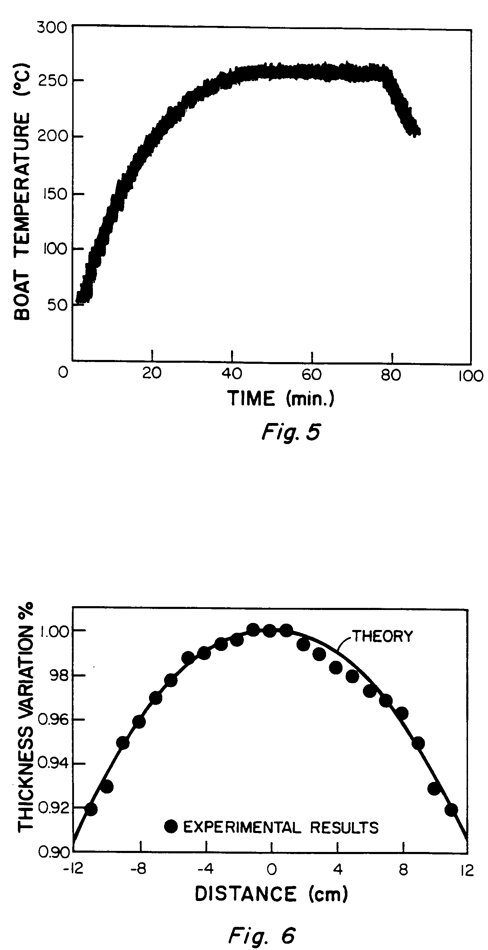

In a specific embodiment, a flat vessel of 50cm x 40cm was used. In this particular configuration, the vessel was directly connected to a fluid heater circulator 42 (Haake HT400/3), as shown in Fig 4. Temperature ramping and soaking is done through the temperature controller of the circulator which can be used in the manual or automatic mode, For the above given vessel dimensions and fluid circulator, the flow of fluid was estimated to be about 18 liters/min and the fluid dynamic pressure drop about 15 kPa. This means that the total fluid volume inside the vessel is replaced every 10 seconds. The vessel has been used to evaporate thick selenium layers (150 to 600 μm thick), into flat aluminum substrates. The temperature profiles of five thermocouples located at different area of the vessel (in the centre and at the four edges of the vessel) are shown in Fig 5. The spatial temperature fluctuation was about ±1°C. Because of its very effective area of evaporation (total surface of the vessel), very high deposition rates were achieved, without exceeding an evaporation temperature for which a very large number of morphological growth defects appear on the film. Also film thickness uniformity, as shown in Fig 6, was in full agreement with theoretical expectation, which also confirms the evaporation uniformity of the vessel design.

In a second configuration, as is shown in Fig 7, two circulators 44 and 46 are independently used for heating and cooling the vessel. Four valves are installed in the fluid circuit in order to direct its path to the vessel, when heating or cooling are required. In this system, the fluid in the first circulator 44 stays always hot, whereas, the fluid in the second circulator 46 is always cool. Heating of the vessel is done by opening valve 48 and closing valve 50. This operation directs the hot fluid to the vessel. Valve 52 remains closed and valve 54 opened. During the cooling cycle, the valve status are reversed. In this configuration, a very rapid heating and cooling can be achieved. Also, a very precise ramping and soaking control could be reached if valves 48 and 52 are replaced by a flow metering valve with a PID closed loop control on temperature.

This new vessel is heated/cooled by circulating a hot/cool fluid in a closed loop circuit. The proposed vessel configuration has several advantages in comparison to conventional electrically heated boats:

(1) Better spatial temperature profiles can be achieved.
(2) Better heating/cooling temperature control.
(3) Higher evaporation area efficiency (100% of cross-section evaporation area).
(4) No electrical current is passed through the boat, this eliminates cross-impedance problems (boat/evaporation material interactions).

The vessel described above is well suited for vacuum thin film coating applications, where very high deposition rates, high production throughput, excellent thickness uniformity, and tight control of layer alloy profiles are required.

Although the invention has been disclosed with reference to a preferred embodiment, it is to be understood that the invention is not limited to such embodiment and that other alternatives are also envisaged.

## Claims

1. An evaporating vessel comprising:
   a) an open top compartment for holding a material to be evaporated; and
   b) a lower closed chamber having an inlet and an outlet and a plurality of heat transfer fluid conducting paths between said inlet and outlet, the arrangement being such that any temperature difference between the inlet and outlet of the lower chamber is low.

2. A vessel as defined in claim 1, wherein the lower chamber comprises a top plate in which there are equally spaced parallel channels to provide parallel ribs in the top plate, and a bottom plate welded to the top plate to close the chamber.

3. A vessel as defined in claim 2, wherein the channels are arranged for series flow of the heat transfer fluid between the inlet and the outlet of the chamber.

4. A vessel as defined in claim 2, wherein the channels are arranged for parallel flow of the heat transfer fluid between the inlet and the outlet of the chamber.

5. A vessel as defined in any preceding claim, further comprising a fluid heat circulator for circulating the heat transfer fluid through the inlet and outlet of the vessel.

6. A vessel as defined in any one of claims 1-4, further comprising two circulators connected to the inlet and outlet of the vessel for independently heating and cooling the vessel.

7. A method of operating a vessel as defined in any preceding claim, including the steps of passing the heat transfer fluid through the lower chamber and evaporating the material.

8. A method as defined in claim 7, wherein the material is a low temperature melting material.

9. A method as defined in claim 7 or 8, wherein the material may be evaporated in the temperature range of 20 to 600°C.

**10.** A method as defined in any one of claims 7-9, wherein the material is selenium, tellurium or arsenic triselenide.

**11.** A method as defined in any one of claims 7-10, including the step of vacuum depositing the vapor on a substrate.

Fig. 1

Fig. 2a

Fig. 2b

Fig. 3

SPOTWELD

THERMOCOUPLE

30

28

24

32

34

38

40

EP 0 475 574 A1

*Fig. 4*

*Fig. 7*

Fig. 5

Fig. 6

European Patent
Office

# EUROPEAN SEARCH REPORT

Application Number

EP    91 30 7174

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | VACUUM DEPOSITION OF THIN FILMS by L. Holland Chapman and Hall Ltd., London, GB, 1970, pp104-134 * p115, fig 4.1; p119, fig 4.2; p133, fig 4.4 * --- | 1 | C23C14/24 |
| A | SOLID STATE TECHNOLOGY vol. 19, no. 7, July 1976, pages 32 - 40; P. ARCHIBALD: 'SOURCE EVAPORATION SYSTEMS FOR THERMAL EVAPORATION' * page 33; figure 3 * --- | 1 | |
| A | FR-A-2 296 457 (JERSEY NUCLEAR- AVCO ISOTOPES, INC.) ----- | | |

TECHNICAL FIELDS
SEARCHED (Int. Cl.5)

C23C

The present search report has been drawn up for all claims

| Place of search | Date of completion of the search | Examiner |
|---|---|---|
| THE HAGUE | 19 NOVEMBER 1991 | JOFFREAU P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)